# EUROPEAN PATENT SPECIFICATION

(11) **EP 1 512 181 B1**
(45) Date of publication and mention of the grant of the patent: **14.01.2009**
(21) Application number: 03737130.9
(22) Date of filing: 12.06.2003
(51) Int. Cl.: H01L 33/00, H01S 5/00, H01S 5/02

(54) **SEMICONDUCTOR EMITTER COMPRISING A SATURATED PHOSPHOR**
HALBLEITER-STRAHLUNGSQUELLE MIT GESÄTTIGTEM PHOSPHOR
EMETTEUR A L'ETAT SOLIDE AU PHOSPHORE SATURE

(30) Priority: 13.06.2002 US 388327 P
(43) Date of publication of application: 09.03.2005
(73) Proprietor: CREE, INC., Goleta, CA 93117 (US)
(72) Inventor: KELLER, Bernd, Santa Barbara, CA 93111 (US); FU, Yankun, Raleigh, NC 27617 (US); SERUTO, James, Goleta, CA 93117 (US); IBBETSON, James, Santa Barbara, CA 93111 (US); BHARATHAN, Jayesh, Cary, North Carolina 27513 (US)
(74) Representative: Dawson, Elizabeth Ann
(86) International application number: PCT/US2003/019000
(87) International publication number: WO 2003/107441

(56) References cited:
- EP-A- 1 282 171
- EP-A- 1 296 383
- WO-A-01/24229
- WO-A-01/24283
- WO-A-01/24284
- WO-A-02/059982
- US-A- 3 593 055
- US-A1- 2003 038 596

## Description

### BACKGROUND OF THE INVENTION

### Field of the Invention

This invention relates to solid state emitters and more particularly to light emitting diodes (LEDs) or laser diodes whose wavelength of emitted light is converted by a conversion material.

### Description of the Related Art

Light emitting diodes (LEDs) are solid-state devices that convert electric energy to light, and generally comprise an active layer of semiconductor material sandwiched between two oppositely doped semiconductor layers. When a bias is applied across the doped layers, holes and electrons are injected into the active layer where they recombine to generate light. Light is emitted omnidirectionally from the active layer and from all surfaces of the LED. Recent advances in LEDs (such as Group III nitride based LEDs) have resulted in highly efficient light sources that surpass the efficiency of filament-based light sources, providing light with equal or greater brightness in relation to input power.

Solid-state semiconductor laser diodes convert electrical energy to light in much the same way as LEDs. They are structurally similar to LEDs but include mirrors on two opposing surfaces, one of which is partially transmissive. In the case of edge emitting lasers, the mirrors are on the side surfaces; the mirrors provide optical feedback so that stimulated emission can occur. This stimulated emission provides a highly collimated/coherent light source. A vertical cavity laser works much the same as an edge emitting laser but the mirrors are on the top and the bottom. It provides a similar collimated output from its top surface. Some types of solid-state lasers can be more efficient than LEDs at converting electrical current to light.

Green emitting LEDs can be fabricated from different material systems including the Group III nitride based material system. Conventional green emitting LEDs, however, are typically subject to low yield and are considered difficult to fabricate with uniform emission characteristics from batch to batch. The LEDs can also exhibit large wavelength variations across the wafer within a single batch, and can exhibit strong wavelength and emission variations with operation conditions such as drive current and temperature.

Phosphors, polymers and dyes have been used to surround LEDs to downconvert the LED's light to a different wavelength, thereby modifying the light emitted by the LED. For example, a single blue emitting LED has been surrounded with a yellow phosphor, polymer or dye, with a typical phosphor being cerium-doped yttrium aluminum garnet (Ce:YAG). [See Nichia Corp. white LED, Part No. NSPW300BS, NSPW312BS, etc.; See also U.S. Patent No. 5,959,316 to Lowery, "Multiple Encapsulation of Phosphor-LED Devices"]. The surrounding phosphor material "downconverts" the wavelength of some of the LED light and re-emits it as a different wavelength such that the overall "LED package" emits two wavelengths of light. In the case of a blue emitting LED surrounded by a yellow phosphor, some of the blue light passes through the phosphor without being converted, while the remaining light is downconverted to yellow. The blue light passing through the phosphor plays a major role in the overall color of light emitted by the LED package, which emits both blue and yellow light that combine to provide a white light.

In these types of LED packages, it can be difficult to apply the downconverting materials in such a way that the light source (LED) emits homogeneous light. Replicability and mass production also presents problems because even slight fluctuations in the layer thickness of the conversion material can change the color of emitted light. U.S. Patent No. 6,066,861 to Hohn et al. discloses a casting composition that surrounds an LED and contains conversion material in stable dispersion such that the light from the LED appears more homogeneous. In one embodiment, the conversion material (luminous substance), is a phosphor group of the general formula A₃B₅X₁₂:M having particles sizes <20 µm and a mean grain diameter d₅₀<5 µm. Similar to the LED package having a yellow conversion material surrounding a blue LED, the casting composition is arranged so that a substantial portion of the LED light passes through, while the remaining LED light is downconverted.

Another disadvantage of the typical blue LED surrounded by a yellow downconverting material is that the resulting white light can have an unacceptable color temperature and poor color rendering such that the LED is not suitable for standard room lighting. U.S. Patent No. 6,252,254 to Soules et al. discloses a blue LED (or a laser diode) covered with a green and red downconverting phosphor. Similar the blue LED surrounded by yellow downconverting material, the green/red phosphor absorbs some of the blue LED light and reemits red and green light, such that the LED and phosphor both emit light that combines as a white light. Soules et al. discloses that the resulting white light has an improved color temperature and improved color rendering.

Another disadvantage of a typical blue LED with yellow downconverting material is that the material can deteriorate, leading to color tone deviation and darkening of the fluorescent material. U.S. Patent No. 5,998,925 to Shimuzu et al. discloses a LED to address this disadvantage by providing a light emitting component (e.g. LED or laser diode) and a phosphor capable of absorbing part of the light emitted by the light emitting component and emitting light of a wavelength different from that of the absorbed light. The light emitting component comprises a nitride based semiconductor and the phosphor contains a particular garnet fluorescent material. Shimuzu et al. discloses that the phosphor has excellent resistance to light so that the fluorescent properties experience little deterioration when used over an extended period of time.

Light extraction is another recognized problem with conventional LEDs, which typically have an active layer and doped layers with a refractive index n of about 3.5. The LEDs are then encapsulated in an epoxy having a refractive index n of about 1.5. Application of Snell's law shows that only light emitted from the active region within an angle theta of about 0.443 radians to normal of the interface with the epoxy can exit from the top of the LED. For larger angles, the light is trapped within the LED by total internal reflection, such that only a fraction of the light (approximately 9.6% in some cases) contributes to light emission. U.S. Patent No. 5,813,753 to Vriens et al. discloses a UV/blue LED phosphor device with enhanced conversion and extraction of light. The device utilizes most of the LED's edge emitted light by the appropriate positioning of reflectors and phosphor. The device also affects angular emission and color of the visible light emitted by the UV/blue LED-phosphor device by the use of one or more dielectric filters on the device. In one embodiment, a light emitting device is placed in a cup-shaped header with a reflector that is then filled with a transparent material having a homogeneously mixed phosphor. The device anticipates that not all of the light will be absorbed by the phosphor and includes a glass plate that is placed on the device that prevents UV/blue light which is not absorbed by the phosphor grains from exiting into air. In another embodiment a long wave pass filter (LPW) is added adjacent to the glass plate to reflect UV/blue light back to the phosphor and to transmit visible light emitted by the phosphor.

All of the LED packages described above have a common characteristic. Each relies on or contemplates that a portion of the light from the LED (or laser diode) passes through the conversion material without being absorbed and in most cases the light passing through plays an important role in the overall color emitted by the package.

More recently it has been proposed to replace known inefficient green LEDs with conversion devices, as disclosed in WO-A-01/24229. Here, blue light from a blue LED is converted to green light via a green phosphor. Here it is desired to eliminate a significant amount of the LED blue radiation which may spoil efficiency or color saturation.

WO 0124283 A discloses a light emitting diode package comprising a conversion material layer capable of absorbing all the light emitted by the light emitting diode chip.

### SUMMARY OF THE INVENTION

The present invention seeks to provide semiconductor light emitter packages that are easy to manufacture and provide a high yield, while at the same time providing semiconductor light emitter packages exhibiting limited wavelength variations between batches of packages and exhibit consistent wavelength and emission characteristics with operation over time. This objective is achieved by a semiconductor light emitter package according to claim 1.

In one embodiment of an emitter package according to the present invention, the semiconductor emitter comprises a blue of UV emitting LED, with the LED light passing through a green phosphor according to claims 6 and 7. The phosphor is saturated by the light such that the package emits in the green portion of the spectrum. This arrangement offers a number of advantages over convention nitride-based green LEDs. Unlike green LEDs, the emission spectrum of green phosphor is essentially fixed by the specific material and is accordingly less subject to wavelength variation. Phosphors in general can also have a spectrally broader emission spectrum, which may be desirable in some applications.

The light from an LED passing through a saturated conversion material according to the present invention can be subject to losses due to non-unity conversion efficiency of the phosphor and the Stokes shift. This loss, however, is acceptable because the preferred embodiments of LED packages according to the present invention comprise high efficiency, high yield LEDs, such as UV and blue emitting Group III nitride-based LEDs, which compensate for the losses and result in a LED package with higher emission efficiency compared to typical LEDs.

This technology is well suited for manufacturing and the development of a wide variety of flexible products for solid-state lighting. The possible applications of LED packages according to the present invention include, but are not limited to, traffic lights, displays, specialty illumination, signals, etc. The invention also can be used in combination with blue and red emitters to fabricate a white light emitting LED package, which would be suited for nearly any application requiring high efficiency, high color rendering solid-state lighting. This includes indoor and outdoor commercial and residential architectural lighting, auto taillights, displays, flashbulbs and general lighting. This will result in cumulative energy saving and reduction of environmental impacts.

These and other further features and advantages of the invention will be apparent to those skilled in the art from the following detailed description, taken together with the accompanying drawing, in which:

### BRIEF DESCRIPTION OF THE DRAWINGS

FIG. 1 is a sectional view of one embodiment of a saturated conversion material LED package according to the present invention;
FIG. 2 is a graph showing the output intensity verses peak emission wavelength of a saturated conversion material LED according to the present invention;
FIG. 3 is a graph showing the wavelength spectrum of saturated conversion material LED according to the present invention;
FIG. 4 is a graph showing the output loss verses operating hours for saturated conversion material LEDs according to the present invention.
FIG. 5 is a sectional view of another embodiment of a saturated conversion material LED package according to the present invention;
FIG. 6 is a sectional view of one embodiment of a saturated conversion material semiconductor laser package according to the present invention;
FIG. 7 is a sectional view of an embodiment of a saturated conversion material emitter package according to the present invention having different concentration layers of conversion material; and
FIG. 8 is a sectional view of an embodiment of a saturated conversion material emitter package according to the present invention having homogeneous concentration of conversion material.

### DETAILED DESCRIPTION OF THE INVENTION

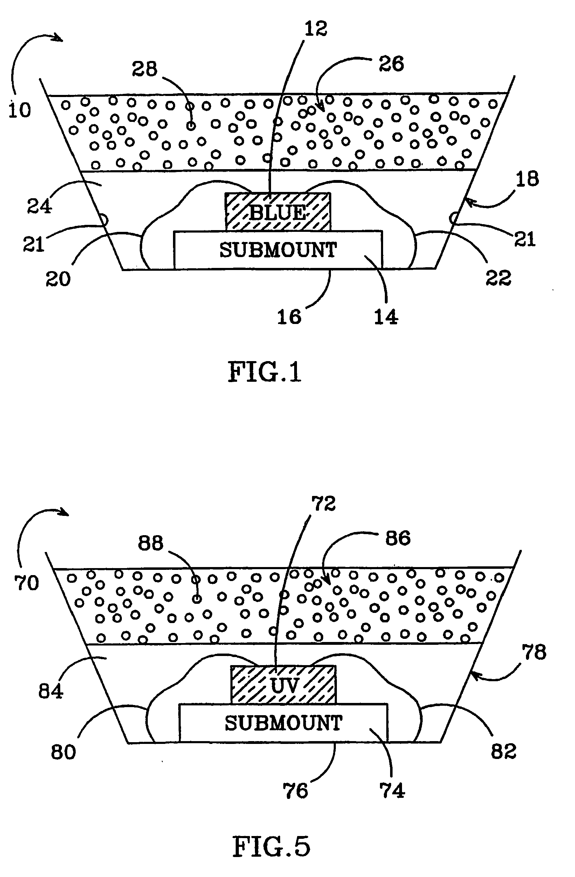

FIG. 1 shows one embodiment of a saturated conversion material LED package 10 according to the present invention. It comprises an LED 12 (although more than one LED can be used) which generally includes an active layer sandwiched between two oppositely doped layers. The layers have standard thicknesses and the active layer emits light omnidirectionally when a bias is applied across the oppositely doped layers. The layers of the LED 12 can be made of many different semiconductor material systems and the LED 12 can emit many different colors of light. The LED 12 preferably emits blue light and can be formed of a semiconductor material from the Group III nitride based material system, which provides for high efficiency radiation of blue light. Group III nitrides refer to those semiconductor compounds formed between nitrogen and the elements in Group III of the periodic table, usually aluminum (Al), gallium (Ga), and indium (In). The term also refers to ternary and tertiary compounds such as AlGaN and AlInGaN.

The LED 12 can also comprise a substrate with the LED's active and oppositely doped layers formed in a stack on the substrate. The substrate can be formed of many different materials such as sapphire (Al₂O₃), silicon (Si) or silicon carbide (SiC), with the preferred substrate being a 4H polytype of SiC. Other SiC polytypes can also be used including 3C, 6H and 15R polytypes. A buffer layer can also be included between the substrate and other LED layers to provide an appropriate crystal structure transition. Silicon carbide has a much closer crystal lattice match to Group III nitrides than sapphire and results in Group III nitride films of higher quality. Silicon carbide also has a very high thermal conductivity so that the total output power of Group III nitride devices on silicon carbide is not limited by the thermal dissipation of the substrate (as is the case with some devices formed on sapphire). The availability of silicon carbide substrates also provides the capacity for device isolation and reduced parasitic capacitance that make commercial devices possible. SiC substrates are available from Cree Research, Inc., of Durham, North Carolina and methods for producing them are set forth in the scientific literature as well as in a U.S. Pat. Nos. Re. 34,861; 4,946,547; and 5,200,022.

The LED's active layer and oppositely doped layers are formed on the substrate using known semiconductor fabrication processes, such as metal-organic chemical vapor deposition (MOCVD). Similarly, techniques for epitaxial growth of Group III nitrides have been reported in scientific literature, and in U.S. Pat. Nos. 5,210,051; 5,393,993; 5,523,589; and 5,292,501.

The LED 12 can also comprise first and second contacts, each of which are arranged in ohmic contact with a respective oppositely doped layer. A bias applied to the contacts is conducted to the oppositely doped layers, resulting in electrons and holes being injected into the LED's active region where they recombine to cause the active layer to emit light.

The LED 12 can also be mounted on a submount 14 for mechanical stability. The submount 14 can contain electrical circuitry for controlling the amount of current or power applied to the LED 12 or to otherwise modify the electric signal applied to the LED 12. The submount 14 can also contain components and circuitry to make the LED package 10 resistant to electrostatic shock. The submount 14 is mounted at the horizontal base 16 of "metal cup" 18 that typically has first and second conductive paths 20, 22 for applying a bias across the LED's contacts to cause the LED 12 to emit light. Alternatively, the bias can be applied to the LED (or its contacts) fully or partially through the submount 16 and its electronic circuitry. The cup 18 can have a reflective surface 21 that reflects light emitted from the LED 12 so that it contributes to the overall light emitted from the package 10.

The LED 12, submount 14 and conductive paths 20, 22 are encased in a protective layer 24 that is made of a radiation hard and transparent material being an epoxy. During manufacturing of the package 10 the epoxy is injected into and fills the bottom portion of the cup 18 such that the LED 12, the submount 16, and conductive paths 20, 22 are covered by the epoxy, and the epoxy is then cured.

The LED 12 further comprises a conversion material layer 26 on top of the transparent material 24, with the layer 26 also being made of a radiation hard and transparent material similar to layer 24, and also has a conversion material 28 distributed throughout. The material 28 can be one or more fluorescent or phosphorescent material such as a phosphor, fluorescent dye or photoluminescent semiconductor. The following list phosphors that can be used as the conversion material 28, grouped by the re-emitted color following excitation:

### RED

Y₂O₂S : Eu³⁺, Bi³⁺

YVO4 : Eu3⁺, Bi³⁺

SrS : Eu²⁺

SrY₂S₄ : Eu²⁺

CaLa2S₄:Ce3⁺

(Ca,Sr)S:Eu²⁺

Y₂O₃ : Eu³⁺, Bi³⁺

Lu₂O₃:Eu³⁺

(Sr₂₋ₓLaₓ) (Ce₁₋ₓEuₓ) O₄

Sr₂Ce₁₋ₓEuₓO₄

Sr₂₋ₓEuₓCeO₄

Sr₂CeO₄

SrTiO₃ : Pr³⁺, Ga³⁺

### ORANGE

SrSiO₃ : Eu, Bi

### YELLOW/GREEN

YBO₃ : Ce³⁺, Tb³⁺

BaMgAl₁₀O₁₇ : Eu²⁺, Mn²⁺

(Sr,Ca,Ba) (Al, Ga)₂S₄ :Eu²⁺

ZnS : Cu⁺, Al³⁺

LaPO₄ : Ce, Tb

Ca₈Mg (SiO₄)₄Cl₂ : Eu²⁺, Mn²⁺

((Gd,Y,Lu,Se,La,Sm)₃(Al,Ga,In)5O₁₂:Ce3⁺

((Gd, Y)₁₋ₓSmₓ)₃(Al_{1-y}Ga_{y})₅O₁₂:Ce³⁺

(Y_{1-p-q-r}GdₚCe_{q}Smᵣ)₃(Al_{1-y}Ga_{y})₅O₁₂

Y₃ (Al₁₋ₛGaₛ)₅O₁₂:Ce³⁺

(Y,Ga,La)₃Al₅O₁₂ : Ce³⁺

Gd₃In₅O₁₂ : Ce³⁺

(Gd, Y)₃Al₅O₁₂ : Ce³⁺, Pr³⁺

Ba₂(Mg,Zn)Si₂O₇ : Eu²⁺

(Y,Ca,Sr)₃(Al,Ga,Si)₅(O,S)₁₂

Gd_{0.46}Sr_{0.31}Al_{1.23}OₓF_{1.38} : Eu^{2+0.06}

(Ba_{1-x-y}SrₓCa_{y})SiO₄ : Eu

Ba₂SiO₄:Eu²⁺

### BLUE

ZnS:Ag,Al

### COMBINED YELLOW/RED

Y₃Al₅O₁₂ : Ce³⁺, Pr³⁺

### WHITE

SrS:Eu²⁺, Ce³⁺, K⁺

From the list above, the following phosphors are most suitable for use as the conversion material 28 in LED package 10 by having excitation in the blue and/or UV emission spectrum, providing a desirable peak emission, having efficient light conversion, and acceptable Stokes shift:

### RED

Lu₂O₃ : Eu³⁺

(Sr₂₋ₓLaₓ) (Ce₁₋ₓEuₓ) O₄

Sr₂Ce₁₋ₓEuₓO₄

Sr₂₋ₓEuₓCeO₄

SrTiO₃ : Pr³⁺, Ga³⁺

### YELLOW/GREEN

(Sr,Ca,Ba) (Al,Ga)₂S₄ : Eu²⁺

Ba₂(Mg,Zn)Si₂O₇ : Eu²⁺

Gd_{0.46}Sr_{0.31}Al_{1.23}OₓF_{1.38} : Eu²⁺_{0.06}

(Ba_{1-x-y}SrₓCa_{y})SiO₄ : Eu

Ba₂SiO₄ : Eu²⁺

During manufacturing, the conversion material layer 26 is injected on top of the layer 24 to fill most, or all, of the cup 18, and is cured. The particles in material 28 absorb light emitted by the UV LED 12 and re-emit the absorbed light at one or more wavelength spectrums that are different from the absorbed wavelength. The conversion material 28 can comprise more than one type of material, each of which re-emits light at a different wavelength so that the conversion material layer 26 re-emits more than one wavelength of light. The conversion material 28 can also be in different concentrations throughout the conversion material layer 26.

The amount of LED light absorbed and re-emitted by the conversion material is generally proportional to the amount of conversion material that the LED light passes through. However, if the LED light passes through too much conversion material 28, part of the conversion material's re-emitted light can be blocked from emitting from the LED package 10, by excess conversion material 28. This can reduce the overall light emitting efficiency of the package 10. The amount of conversion material that the LED light passes through can be varied by varying the concentration of conversion material 28 or varying the thickness of the layer 26, or both.

In LED package 10, light from the LED 12 passes through a sufficient amount of conversion material 28 so that all of the LED light is absorbed and re-emitted at a different wavelength of light. At the same time, the re-emitted light does not pass through an excess conversion material 28 so that the re-emitted light is not blocked from emitting from the package 10. By providing a sufficient amount of conversion material 28 to provide full conversion without blocking, the conversion material 28 is in a "saturation" condition. The amount of conversion material for conversion material saturation depends on the size and luminous flux of the LED 12 (or laser). The greater the size and luminous flux, the greater the amount of conversion material 28 needed.

In conversion material saturation, the emitted light from the package 10 is composed primarily of photons produced by the conversion material 28. For the LED 10, most embodiments of the package 10 emit less than 10% of the emission power of primary radiation in the absence of the conversion material 28; i.e. the conversion material 28 absorbs 90% or more of the light from the LED 12.

As described above, the LED 12 is blue emitting and a suitable conversion material is a green phosphor such as SrGa₂S₄:Eu²⁺ (Sr:Thiogallate) or Gd_{0.46}Sr_{0.31}Al_{1.23}OₓF_{1.38}:Eu⁺²_{0.06}. Sr:Thiogallate has a peak excitation wavelength ranging from 400 to 450nm and the percent of blue light (or UV light) that is absorbed by Sr:Thiogallate and then re-emitted as green light is estimated to be 74% +/-5%, which makes this phosphor one of the more efficient for excitation in the blue (or UV) range. The use of a high efficiency blue emitter in combination with a phosphor that is efficient for excitation in the blue range, results in a saturation conversion material LED package that efficiently emits green.

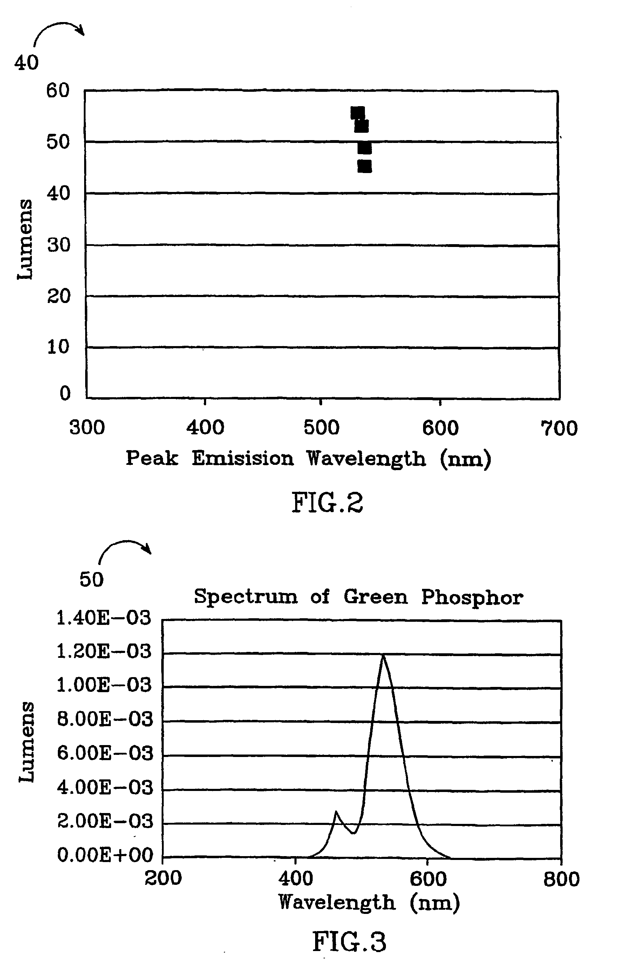

FIGs. 2-4 show results of performance studies completed by applicants on LED packages 10 according to the present invention having a blue LED with green conversion material in saturation. FIG. 2 shows a graph 40 plotting the emission performance in Lumens of four different LED packages according to the present invention at their peak emission wavelength in nanometers (nm), with 350mA applied across the LED in each package. Using a green Sr:Thiogallate phosphor as the conversion material, the LED package emitted up to 58 Lumens at its peak wavelength of approximately 530nm, which is a significant improvement over the performance of typical green emitting LEDs.

FIG. 3 shows a graph 50 plotting the emission spectrum as Intensity in a.u. verses wavelength in nm, of the light re-emitted from green Sr:Thiogallate phosphor from the LED packages. Each package exhibited a similar spectrum having a peak (~70nm full width at half maximum (FWHM) centered at ~530-550nm, which is close to the peak of the general photopic human eye response curve. This results in an emission of green light having high efficacy. Applicants also maintained the operation of each of the LED packages under test and each maintained this emission spectrum without change for approximately 168 hours, showing that the LED packages are stable over time.

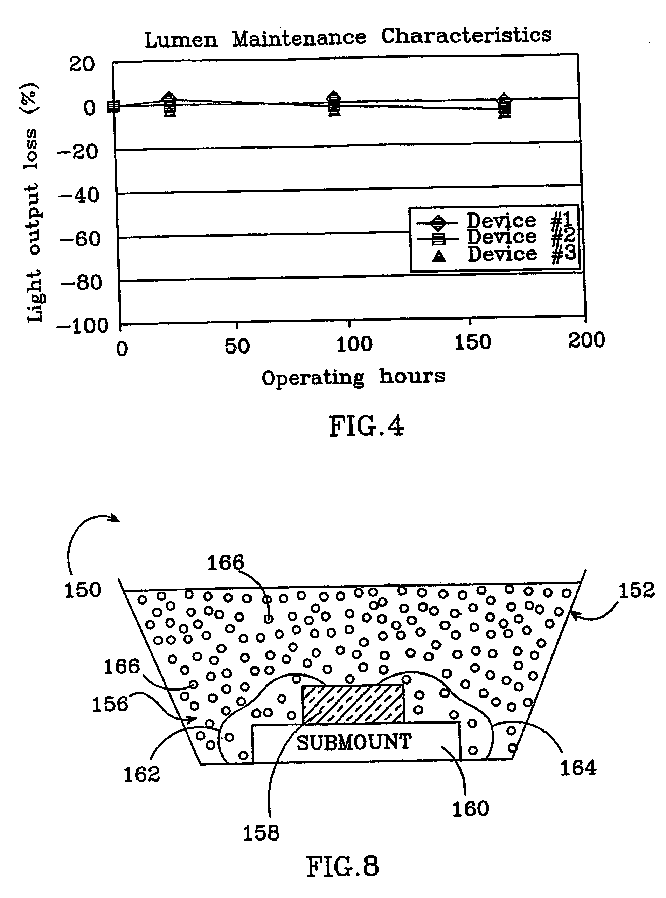

FIG. 4 shows a graph 60 that plots the light output loss over operating hours for three of the four LED packages 10 under test. The graph 60 illustrates that for each, the light output loss is minimal over time. This also shows that the LED packages 10 are stable over time and this performance is consistent with the performance of standard green emitting LEDs.

FIG. 5 shows another embodiment of an LED package 70 according to the present invention, having many similar features as the.package 10 in FIG. 1. It comprises an LED 72 mounted to a submount 74, which is then mounted to the horizontal base 76 of a metal cup 78. First and second conductors 80, 82 are provided to apply a bias across the LED 72, although a bias can be applied in other ways as described above. A protective layer 84 is included over the LED 72, submount 74 and conductive paths 80, 82, and a conversion material layer 86 is included on top of the protective layer 84 and includes a conversion material 88.

The LED 72 is UV emitting and can be made of many different material systems, with a preferred material system being the Group III nitride material system. The conversion material 88 can be any of the materials listed above, but is preferably a green phosphor such as Sr:Thiogallate. The thickness of layer 86 and the concentration of Sr:Thiogallate is such that the conversion material.88 is in saturation, i.e. all of the UV light is absorbed without an excess of conversion material 88 blocking emission of the re-emitted green light. Sr:Thiogallate is efficient at absorbing UV light and re-emitting green light, and using this phosphor in combination with a high efficiency UV LED 72 results in a saturated conversion material LED package 70 that efficiently emits green light.

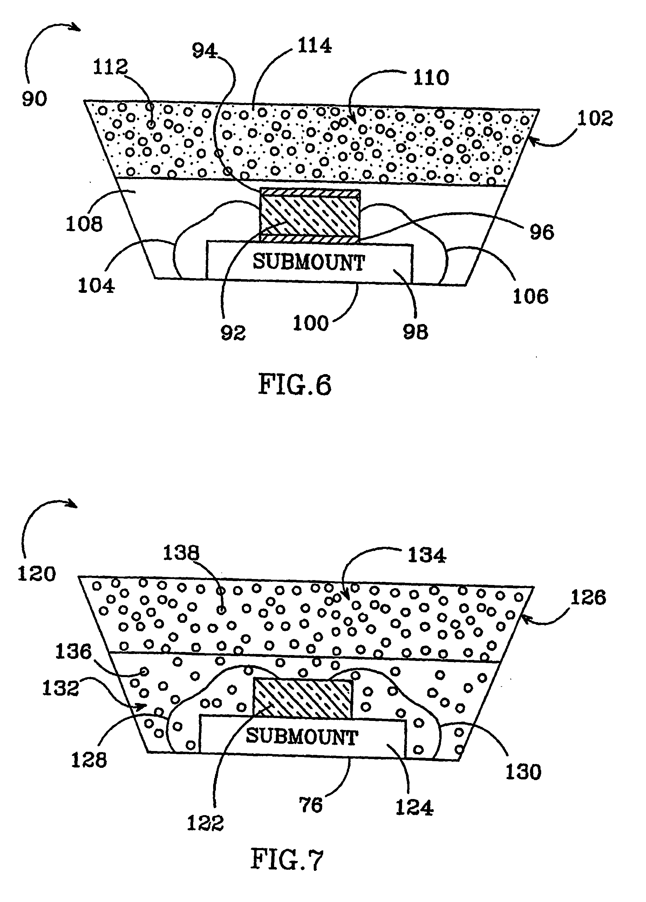

FIG. 6 shows an embodiment of laser diode package 90 according to the present invention having similar features to the packages 10, 70 described above, but instead of having a LED as a light source, the package 90 has a solid-state semiconductor laser diode 92. Mirrors 94, 96 are included on two opposing surfaces of the laser diode 92, with mirror 94 being partially transmissive. The mirrors 94, 96 provide optical feedback so that stimulated emission can occur, which provides a highly collimated/coherent light source. The laser diode 92 can be mounted to a submount 98 that is then mounted to the horizontal base 100 of a metal cup 102 having conductors paths 104, 106 to apply a bias to the laser diode 92. The laser diode 92, submount 98 and conductive paths 104, 106 are covered in a protective layer 108. A conversion layer 110 is included on the protective layer 108 and comprises a conversion material 112, which, can be any of the conversion materials discussed above.

Different laser diodes emitting different colors of light can be used for diode 92 and the conversion material 112 is arranged so that the light from the laser diode 92 passes through it and the LED package 90 operates in saturation of the conversion material 112. All of the light from diode 92 is absorbed by the conversion material 112 and re-emitted as a different wavelength of light, while minimizing the amount of re-emitted light blocked by excess conversion material 112.

To improve the uniformity of light emitting from the package 90, it can be desirable to scatter the light as it passes through the layers 108, 110, particularly in the case of collimated/coherent light from the laser diode 92. One way to scatter light is by using scattering particles 114 that randomly refract light. To effectively scatter light, the diameter of the particles 114 should be approximately one half of the wavelength of the light being scattered. In package 90 the scattering particles 114 are shown in layer 110, although they can also be included in layer 108 or formed in another layer arranged on the layer 110. Light from the diode 92 passes through the particles 114 and is refracted to mix and spread the light as it passes through the conversion material.

The scattering particles 114 are shown evenly distributed throughout layer 100 but they can also be distributed in varying concentrations throughout the layer 114 to most effectively scatter the light by matching the pattern of LED light passing through the layer 114. The preferred, scattering particles would not substantially absorb laser diode light and would have a substantially different index of refraction than the material in which it is embedded (for example, epoxy). The scattering particles 114 should have as high of an index of refraction as possible. Suitable scattering particles can be made of titanium oxide (TiO₂) which has a high index of refraction (n=2.6 to 2.9) and is effective at scattering light. Since the primary requirement for the scattering "particles" is that they have a different index of refraction from their surrounding material and that they have a particular size range, other elements such as small voids or pores could also be used as "scattering particles".

FIG. 7 shows another embodiment of an emitter package 120 having a semiconductor emitter 122 that is either a LED or a laser diode. Like the packages 10, 70 and 90 above, the package 120 has a submount 124, reflective cup 126, first and second conductors 128, 130, a protective layer 132 and a conversion material layer 134. However, in the package 120 the protective layer 132 contains a concentration of conversion particles 136 that is different from the concentration of conversion particles 138 in layer 134. The particles 136 can also be a different type from the particles 138, such that layer 132, 134 each re-emits a different color of light. In both embodiments, the package 120 is arranged to operate in conversion material saturation.

FIG. 8 shows another embodiment of an emitter package 150 according to the invention that is the same as the package 120 in FIG. 7, but instead of having a protective layer 132 and a conversion material layer 134 as shown in FIG. 7, the cup 152 in package 150 is filled with a single conversion layer 156 that serves to protect the packages emitter 158, submount 160, and conductive paths 162, 164 and contains a conversion material 166 distributed throughout. The conversion material can be homogeneously distributed or distributed in different concentrations. Like above, the package 150 operates in conversion material saturation such that all of the light from the emitter 158 is absorbed and re-emitted without the conversion material 166 significantly blocking the re-emitted light.

Although the present invention has been described in considerable detail with reference to certain preferred configurations thereof, other versions are possible. Each of the LED package embodiments described above can have different components having different features. Each of the LED packages above can have emitters made of different material systems and each can include scattering particles. Other conversion materials beyond those listed above can be used.

## Claims

1. A semiconductor light emitter package (10;70;90;120;150), comprising:
one or more semiconductor light emitters (12;72;92;122;158), each of which emits light in response to an electrical current;
a conversion material (28;88;112;138;166) arranged such that light from said semiconductor light emitters passes through said conversion material, said conversion material absorbing light from said semiconductor light emitters and re-emitting light at one or more different wavelengths of light, whereby the amount of conversion material provided is such that is sufficient to absorb all of the light emitting from said semiconductor light emitters, ,
**characterised in that** the amount of conversion material provided is such that there is not an excess of conversion material to block said re-emitted light.

2. A semiconductor light emitter package as claimed in claim 1 comprising a conversion material layer (26;86;110;134;156) throughout which the conversion material is distributed.

3. The semiconductor emitter package of claim 1 or 2, wherein said semiconductor light emitters are light emitting diodes or laser diodes made of semiconductor materials from Group III nitride based material system.

4. The semiconductor light emitter package of claim 1, 2 or 3 wherein said conversion material is one or more materials from the group consisting of phosphors, fluorescent dyes and photoluminescent semiconductors.

5. The semiconductor light emitter package of any preceding claim, wherein said conversion material has peak excitation wavelength in the range of 400 to 450 nm.

6. The semiconductor light emitter package of claim 1 or 2, wherein said semiconductor light emitters are blue light emitting and said conversion material is SrGa₂S₄:Eu²⁺ or Gd_{0.46}Sr_{0.31}Al_{1.23}OₓF_{1.38}:Eu²⁺_{0.06}, said semiconductor light emitter package emitting green light from said conversion material.

7. The semiconductor light emitter package of claim 1 or 2, wherein said semiconductor light emitters are ultra violet light emitting and said conversion material is SrGa₂S₄:Eu²⁺ or Gd_{0.46}Sr_{0.31}Al_{1.23}OₓF_{1.38}:Eu²⁺_{0.06}, said semiconductor light emitter package emitting green light from said conversion material.

8. The semiconductor light emitter package as claimed in any preceding claim comprising:
a metal cup (18;78;102;126;152), said semiconductor light emitters arranged at the base of said cup; and
a plurality of electrically conductive paths (20;22;80;82;104;106;128;130;162;164) coupled to said semiconductor light emitters for applying an electrical current to said semiconductor light emitters.

9. The semiconductor light emitter package of claim 8 further comprising a layer (24;84;108;132) of protective material in said metal cup and covering said semiconductor light emitters and electrically conductive paths, said layer of protective material being a transparent epoxy, said package further comprising a conversion material layer on said protective epoxy layer, said conversion material distributed throughout said conversion material layer.

10. The semiconductor light emitter package of claim 9, wherein said protective layer contains conversion material at a different concentration than said conversion material in said conversion material layer.

11. The semiconductor light emitter package of any preceding claim, further comprising scattering particles (114) to disperse light from said semiconductor light emitters.

## Patentansprüche

1. Halbleiter-Lichtemitter-Baugruppe (10; 70; 90; 120; 150), die Folgendes umfasst:
einen oder mehrere Halbleiter-Lichtemitter (12; 72; 92; 122; 158), von denen jeder als Reaktion auf einen elektrischen Strom Licht emittiert;
ein Umwandlungsmaterial (28; 88; 112; 138; 166), das derart angeordnet ist, dass Licht aus den Halbleiter-Lichtemittern durch das Umwandlungsmaterial strömt, wobei das Umwandlungsmaterial Licht aus den Halbleiter-Lichtemittern absorbiert und Licht in einer oder mehreren unterschiedlichen Lichtwellenlängen reemittiert, wobei die Menge an bereitgestelltem Umwandlungsmaterial derart ist, dass es dazu ausreicht, das gesamte Licht zu absorbieren, das von den Halbleiter-Lichtemittern emittiert wird,
**dadurch gekennzeichnet, dass** die Menge an bereitgestelltem Umwandlungsmaterial derart ist, dass kein Überschuss an Umwandlungsmaterial vorliegt, dass das reemittierte Licht blockiert.

2. Halbleiter-Lichtemitter-Baugruppe nach Anspruch 1, die eine Umwandlungsmaterialschicht (26; 86; 110; 134; 156) umfasst, in der das Umwandlungsmaterial verteilt ist.

3. Halbleiter-Lichtemitter-Baugruppe nach Anspruch 1 oder 2, wobei es sich bei den Halbleiter-Lichtemittern um Leuchtdioden oder Laserdioden handelt, die aus Halbleitermaterialien aus dem auf Gruppe-III-Nitriden basierenden Materialsystem hergestellt sind.

4. Halbleiter-Lichtemitter-Baugruppe nach Anspruch 1, 2 oder 3, wobei es sich bei dem Umwandlungsmaterial um ein oder mehrere Materialien aus der Gruppe bestehend aus Phosphoren, Fluoreszenzfarbstoffen und photolumineszierenden Halbleitern handelt.

5. Halbleiter-Lichtemitter-Baugruppe nach einem der vorhergehenden Ansprüche, wobei das Umwandlungsmaterial eine Spitzenanregungswellenlänge im Bereich von 400 bis 450 nm aufweist.

6. Halbleiter-Lichtemitter-Baugruppe nach Anspruch 1 oder 2, wobei die Halbleiter-Lichtemitter blaues Licht emittieren und es sich bei dem Umwandlungsmaterial um SrGa₂S₄:Eu²⁺ oder Gd_{0,46}Sr_{0,31}Al_{1,23}OₓF_{1,38}:Eu²⁺_{0,06} handelt, wobei die Halbleiter-Lichtemitter-Baugruppe aus dem Umwandlungsmaterial grünes Licht emittiert.

7. Halbleiter-Lichtemitter-Baugruppe nach Anspruch 1 oder 2, wobei die Halbleiter-Lichtemitter ultraviolettes Licht emittieren und es sich bei dem Umwandlungsmaterial um SrGa₂S₄:Eu²⁺ oder Gd_{0,46}Sr_{0,31}Al_{1,23}OₓF_{1,38}:Eu²⁺_{0,06} handelt, wobei die Halbleiter-Lichtemitter-Baugruppe aus dem Umwandlungsmaterial grünes Licht emittiert.

8. Halbleiter-Lichtemitter-Baugruppe nach einem der vorhergehenden Ansprüche, die Folgendes umfasst:
einen Metallbecher (18; 78; 102; 126; 152), wobei die Halbleiter-Lichtemitter am Boden des Bechers angeordnet sind; und
mehrere elektrisch leitende Leiterbahnen (20; 22; 80; 82; 104; 106; 128; 130; 162; 164), die mit den Halbleiter-Lichtemittern verbunden sind, um einen elektrischen Strom auf die Halbleiter-Lichtemitter anzulegen.

9. Halbleiter-Lichtemitter-Baugruppe nach Anspruch 8, die weiterhin eine Schicht (24; 84; 108; 132) aus Schutzmaterial in dem Metallbecher umfasst, die die Halbleiter-Lichtemitter und leitenden Leiterbahnen abdeckt, wobei die Schicht aus Schutzmaterial ein transparentes Epoxid ist, wobei die Baugruppe weiterhin eine Umwandlungsmaterialschicht auf der Epoxidschutzschicht umfasst, wobei das Umwandlungsmaterial in der Umwandlungsmaterialschicht verteilt ist.

10. Halbleiter-Lichtemitter-Baugruppe nach Anspruch 9, wobei die Schutzschicht Umwandlungsmaterial in einer anderen Konzentration als das Umwandlungsmaterial in der Umwandlungsmaterialschicht enthält.

11. Halbleiter-Lichtemitter-Baugruppe nach einem der vorhergehenden Ansprüche, die weiterhin Streuungspartikel (114) umfasst, um Licht aus den Halbleiter-Lichtemittern zu zerstreuen.

## Revendications

1. Ensemble d'émetteurs de lumière à semiconducteurs (10 ; 70 ; 90 ; 120 ; 150), comprenant :
un ou plusieurs émetteurs de lumière à semiconducteurs (12 ; 72 ; 92 ; 122 ; 158), chacun desquels émet une lumière en réponse à un courant électrique ;
un matériau de conversion (28 ; 88 ; 112 ; 138 ; 166) agencé de sorte que la lumière desdits émetteurs de lumière à semiconducteurs passe au travers dudit matériau de conversion, ledit matériau de conversion absorbant la lumière desdits émetteurs de lumière à semiconducteurs et réémettant la lumière à une ou plusieurs longueurs d'onde de lumière différentes, ce par quoi la quantité de matériau de conversion pourvue est telle qu'elle est suffisante pour absorber toute la lumière émettant depuis lesdits émetteurs de lumière à semiconducteurs,
**caractérisé en ce que** la quantité de matériau de conversion pourvue est telle qu'il n'y a pas de matériau de conversion en excès pour bloquer ladite lumière réémise.

2. Ensemble d'émetteurs de lumière à semiconducteurs tel que revendiqué à la revendication 1, comprenant une couche de matériau de conversion (26 ; 86 ; 110 ; 134 ; 156) au travers de laquelle le matériau de conversion est distribué.

3. Ensemble d'émetteurs à semiconducteurs tel que revendiqué à la revendication 1 ou à la revendication 2, dans lequel lesdits émetteurs de lumière à semiconducteurs sont des diodes électroluminescentes ou des diodes laser fabriquées dans des matériaux semiconducteurs du système de matériaux à base de nitrures de groupe III.

4. Ensemble d'émetteurs de lumière à semiconducteurs tel que revendiqué à la revendication 1, la revendication 2 ou la revendication 3, dans lequel ledit matériau de conversion est un ou plusieurs matériaux parmi le groupe constitué de phosphores, de colorants fluorescents et de semiconducteurs photoluminescents.

5. Ensemble d'émetteurs de lumière à semiconducteurs tel que revendiqué dans l'une quelconque des revendications précédentes, dans lequel le matériau de conversion a une longueur d'onde d'excitation de crête dans la gamme de 400 à 450 nm.

6. Ensemble d'émetteurs de lumière à semiconducteurs tel que revendiqué à la revendication 1 ou à la revendication 2, dans lequel lesdits émetteurs de lumière à semiconducteurs émettent une lumière bleue et ledit matériau de conversion est SrGa₂S₄:Eu²⁺ ou Gd_{0,46}Sr_{0,31}Al_{1,23}OₓF_{1,38}:Eu²⁺_{0,06}, ledit ensemble d'émetteurs de lumière à semiconducteurs émettant une lumière verte dudit matériau de conversion.

7. Ensemble d'émetteurs de lumière à semiconducteurs tel que revendiqué à la revendication 1 ou à la revendication 2, dans lequel lesdits émetteurs de lumière à semiconducteurs émettent une lumière ultraviolette et ledit matériau de conversion est SrGa₂S₄:Eu²⁺ ou Gd_{0,46}Sr_{0,31}Al_{1,23}OₓF_{1,38}:Eu²⁺_{0,06}, ledit ensemble d'émetteurs de lumière à semiconducteurs émettant une lumière verte dudit matériau de conversion.

8. Ensemble d'émetteurs de lumière à semiconducteurs tel que revendiqué dans l'une quelconque des revendications précédentes, comprenant :
une coupelle métallique (18 ; 78 ; 102 ; 126 ; 152), lesdits émetteurs de lumière à semiconducteurs étant agencés à la base de ladite coupelle ; et
une pluralité de chemins électriquement conducteurs (20 ; 22 ; 80 ; 82 ; 104 ; 106 ; 128 ; 130 ; 162 ; 164) couplés aux dits émetteurs de lumière à semiconducteurs pour appliquer un courant électrique aux dits émetteurs de lumière à semiconducteurs.

9. Ensemble d'émetteurs de lumière à semiconducteurs tel que revendiqué à la revendication 8, comprenant en outre une couche (24 ; 84 ; 108 ; 132) de matériau de protection dans ladite coupelle métallique et couvrant lesdits émetteurs de lumière à semiconducteurs et les chemins électriquement conducteurs, ladite couche de matériau de protection étant une couche époxy transparente, ledit ensemble comprenant en outre une couche de matériau de conversion sur ladite couche époxy de protection, ledit matériau de conversion étant distribué dans l'ensemble de ladite couche de matériau de conversion.

10. Ensemble d'émetteurs de lumière à semiconducteurs tel que revendiqué à la revendication 9, dans lequel ladite couche de protection contient un matériau de conversion à une concentration différente que ledit matériau de conversion dans ladite couche de matériau de conversion.

11. Ensemble d'émetteurs de lumière à semiconducteurs tel que revendiqué dans l'une quelconque des revendications précédentes, comprenant en outre des particules de dispersion (114) pour disperser la lumière desdits émetteurs de lumière à semiconducteurs.
